Europäisches Patentamt

**European Patent Office**

**Office européen des brevets**

(11) Publication number: **0 152 668**
A2

(12) # EUROPEAN PATENT APPLICATION

(21) Application number: **84304411.6**

(22) Date of filing: **28.06.84**

(51) Int. Cl.⁴: **C 23 C 16/44**

(30) Priority: **17.02.84 US 581104**

(43) Date of publication of application: **28.08.85**
Bulletin 85/35

(84) Designated Contracting States: **AT BE CH DE FR GB IT LI LU NL SE**

(71) Applicant: **STAUFFER CHEMICAL COMPANY, Westport Connecticut 06881 (US)**

(72) Inventor: **Baumann, John Andrew, 112 Pine Avenue, Ossining, NY 10562 (US)**
Inventor: **Gersten, Susan Wendy, 1504 Old Country Road, Elmsford, NY 10523 (US)**
Inventor: **Kuck, Mark Allen, 445 Warfield Street, Upper Montclair, N.J. 07043 (US)**
Inventor: **Raccah, Paul Mordecai, 7521 North Albany, Chicago, Ill. 60645 (US)**

(74) Representative: **Smith, Sydney et al, Elkington and Fife High Holborn House 52/54 High Holborn, London WC1V 6SH (GB)**

(54) **High vacuum deposition processes employing a continuous pnictide delivery system.**

(57) A film deposition apparatus characterised in that it comprises:

(A) a reservoir containing heated pnictide;

(B) means for passing an inert gas therethrough;

(C) a high vacuum film deposition chamber; and

(D) means for supplying the said inert gas carrying the said pnictide as a vapour species after passing through the said pnictide to the said deposition chamber is disclosed.

A high vacuum deposition process characterised in that it comprises passing an inert gas through heated pnictide and supplying the product gas to a vacuum chamber maintained at a pressure below $10^{-3}$ Torr ($1.33 \times 10^{-1}$ Pa) is also disclosed.

Referring to the accompanying illustrative diagram, the present apparatus may comprise reservoir (30), means for passing inert gas therethrough (28), deposition chamber (22) and supply means (60).

Films of pnictide, polypnictide and other pnictide compounds may be deposited for semiconductor and other applications including insulation and passivation, particularly on III-V semiconductors.

The present invention represents an advance over the prior art.

0152668

High Vacuum Deposition processes employing a contin-
uous Pnictide delivery system.

This invention relates to high vacuum deposition
processes employing a continuous pnictide delivery
system; more particularly, it relates to such a
system, to film deposition, to sources of $Pnictide_4$
vapour species, to the deposition of films of pnictides, polypnictides and other pnictide compounds,
particularly when the pnictide is phosphorus, to
vacuum deposition and molecular beam epitaxy, to
semiconductor devices, particularly III-V semiconductor devices and to the insulation and passivation thereof.

For further information, reference may be made
to, for example, GB-A- 2,113,663 and to the related
applications filed herewith, in particular those
based on USSN 581,139, USSN 509,158, USSN 509,175,
USSN 581,115, USSN 509,158, USSN 581,103, USSN 581,
105, USSN 581,102 and USSN 581,101.

$Pnictide_4$ vapour species, particularly $P_4$, are
required for use in various high vacuum film deposition processes, for example, processes for the
deposition of films of phosphorus, polyphosphides
and other phosphorus compounds for use in semiconductor devices. These films may be deposited by
vacuum deposition and molecular beam epitaxy. It
is highly desirable that a source of the $Pnictide_4$
vapour species be capable of delivering very pure,
accurately metered amounts of the species into these
processes. It is also highly desirable to be able
continuously to supply the $Pnictide_4$ vapour species
for an indefinite period of time for depositing films
on large areas and for continuous processing.

A continuous pnictide delivery system has been
employed in chemical vapour deposition and in sputtering to deliver the $Pnictide_4$ species. Reference

may be made in this connection to the above-mentioned related applications, in particular those based on USSN 581,102 and 581,103.

It is therefore an object of the present invention to provide a $Pnictide_4$, particularly a $P_4$, delivery system for high vacuum film deposition.

Another object of the present invention is to provide such a continuous source.

A further object of the present invention is to provide such a source utilizing an inert carrier gas.

Yet another object of the present invention is to facilitate the deposition of films of pnictides, polypnictides and other pnictide compounds, particularly when the pnictide is phosphorus, by vacuum deposition and molecular beam epitaxy.

The present invention provides a film deposition apparatus characterised in that it comprises:

    (A) reservoir containing heated pnictide;

    (B) means for passing an inert gas therethrough;

    (C) a high vacuum film deposition chamber; and

    (D) means for supplying the said inert gas carrying the said pnictide as a vapour species after passing through the said pnictide to the said deposition chamber.

The apparatus may comprise a deposition chamber comprising a molecular collimator. It may comprise a heated pnictide cracker, such as an electrically heated filament, for example at above 1000°C, for cracking pnictide vapour species, in particular $Pnictide_4$, to $Pnictide_2$ species.

The present invention also provides a high vacuum deposition process characterised in that it comprises passing an inert gas through heated pnictide and supplying the product gas to a vacuum chamber maintained at a pressure below $10^{-3}$ Torr ($1.33 \times 10^{-1}$ Pa).

The product gas may be collimated and/or thermally cracked in the chamber. Deposition may take place in a molecular flow regime. Preferably, the pressure is below $10^{-4}$ Torr (1.33 x $10^{-2}$ Pa). The pnictide may be phosphorus, arsenic or antimony.

For a fuller understanding of the nature and objects of the present invention reference may also be made to the accompanying drawings wherein:

Figure 1 illustrates a Pnictide$_4$ source for film deposition in a vacuum apparatus;

Figure 2 illustrates a vacuum deposition apparatus according to the present invention; and

Figure 3 illustrates a molecular beam deposition apparatus according to the present invention.

The same reference numbers refer to the same elements throughout the several views of the drawings.

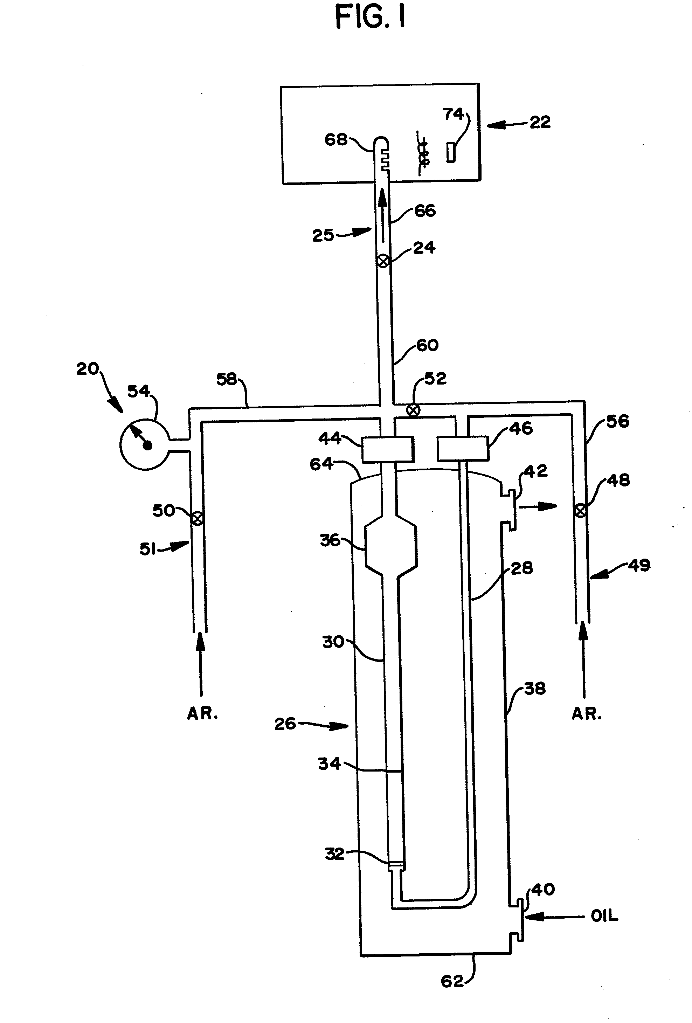

In general terms, in a continuous pnictide delivery system according to the present invention as illustrated in accompanying Figure 1, an inert carrier gas, such as argon, passes down a length of tubing and then upwardly through a sintered glass frit before passing through a vertical column of pnictide, such as liquid white phosphorus or granular arsenic or antimony. The pnictide-enriched carrier gas then exits through the top of the column and may be diluted by a stream of pure carrier gas. The mixture of the Pnictide$_4$ vapour species and the carrier gas is then fed into a high vacuum chamber, after passing through a metering valve. The temperature of the bubbler is maintained constant by a circulating bath of oil heated to between the melting and boiling points of 44°C and 280°C, respectively, for phosphorus or to a temperature sufficiently high to increase the sublimation of arsenic or antimony. The temperature of the downstream transfer lines is maintained by the use of heating tapes. The pressure in the feed system is controlled by a downstream metering valve.

Thus, the concentration of Pnictide$_4$ species fed

into a system may be controlled by regulating the flow of the carrier gas, the temperature of the pnictide in the reservoir and the pressure maintained in the feed system.

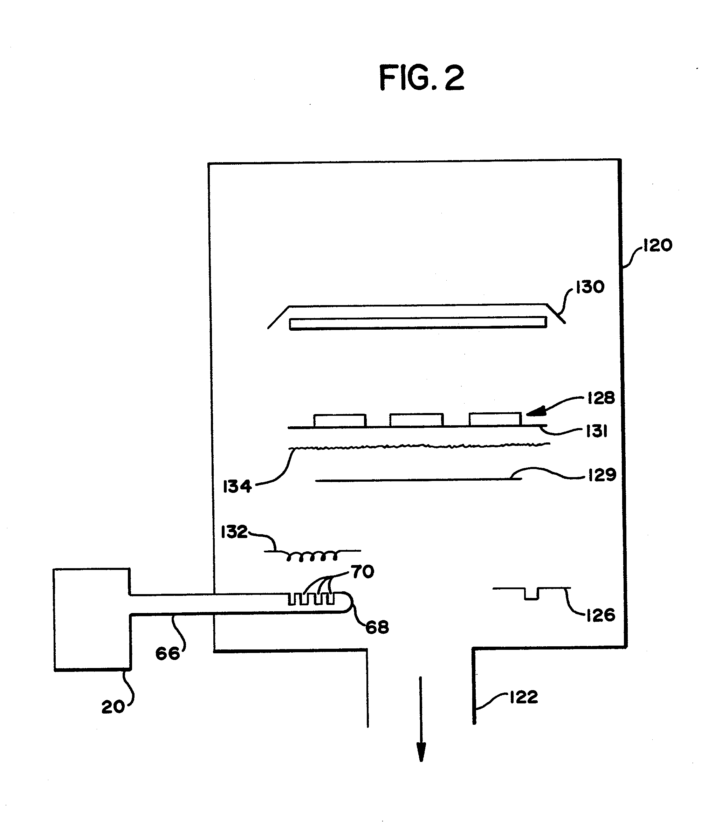

In a vacuum evaporation system according to the present invention, as illustrated in accompanying Figure 2, the pnictide source 20 is connected by tube 66 to a nozzle 68 within vacuum chamber 120. The $Pnictide_4$ species carried by the inert gas exits nozzle 68 through slots 70 cut therein, is cracked at cracker 132 and 134 and then deposited on substrate 128.

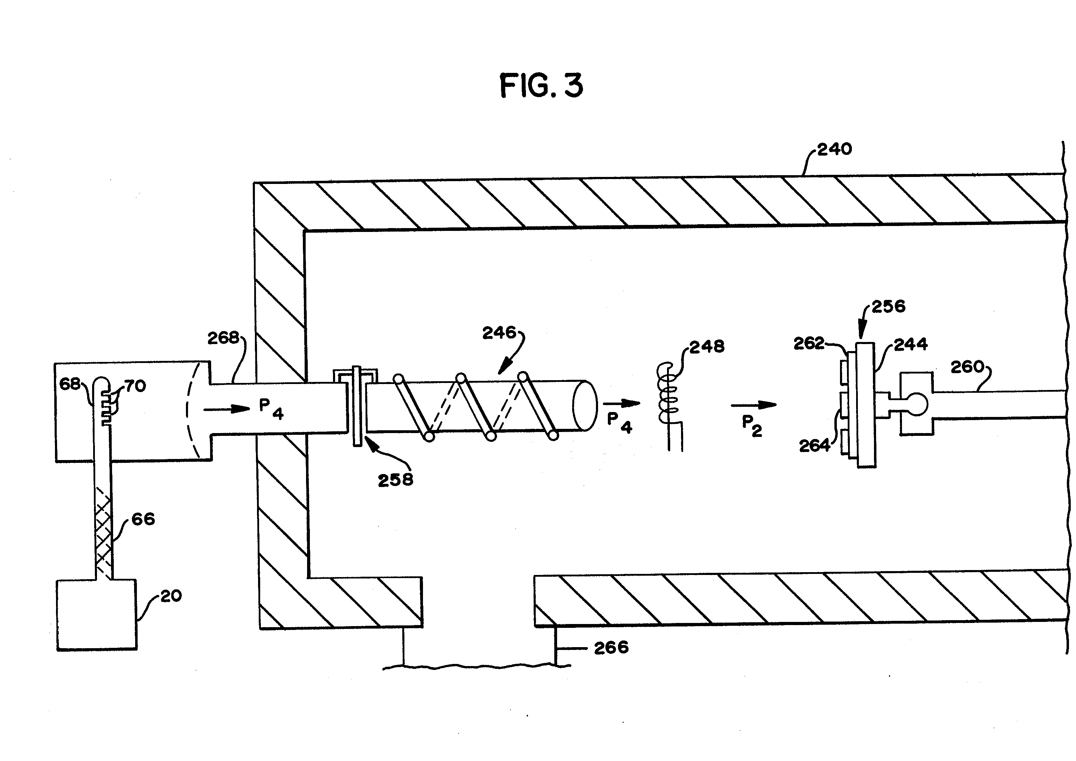

A molecular beam system according to the present invention, as illustrated in accompanying Figure 3, places the nozzle 68 at the inlet port 268 substituting it for a Knudsen cell furnace. The $Pnictide_4$ molecules are collimated by baffle 246 cracked to $Pnictide_2$ at filament 248 and deposited on the substrates 264.

The high vacuum systems (pressure below $10^{-3}$ Torr) $(1.33 \times 10^{-1}$ Pa) preferably below $10^{-4}$ Torr $(1.33 \times 10^{-2}$ Pa) in the molecular flow regime) disclosed herein may be used to deposit passivating, insulating and surface recombination velocity reducing layers of a new form of amorphous phosphorus having a layer-like, puckered sheet-like local order structure on III-V semiconductors and to deposit similar layers of other pnictide compounds or elements.

In more detail now, referring to accompanying Figure 1, a continuous pnictide delivery system according to the present invention is generally indicated at 20. It is connected to supply $Pnictide_4$ species carried by an inert carrier gas to chemical vapour deposition apparatus 22 through metering valve 24.

The pnictide source according to the present invention is generally indicated at 26. It comprises a vertical carrier gas feed tube 28 and vertical pnictide-containing reservoir 30. A coarse porous glass frit disc 32 is located at the bottom of the reservoir 30 to disperse the carrier gas stream which passes through the pnictide in the reservoir 30. Any bubbles forming above the top surface 34 of, for example, liquid phosphorus, if that is used, are collected and break at the enlarged portion 36 of the reservoir 30.

The entire reservoir 30 and carrier gas feed tube 28 are enclosed in jacket 38. Oil from a constant temperature bath is constantly circulated, entering at opening 40 and exiting at opening 42.

The pnictide source 26 may be conveniently attached to the system 20 via connectors 44 and 46. The pnictide source 26 may be disconnected from the oil bath by disconnecting appropriate connectors at 40 and 42. The entire pnictide source 26 and apparatus 20 may be disconnected by connecting (not shown) at 49, 51 and 25 and may be carried into a glove box purged with an inert gas, such as nitrogen, filled with pnictide and removed from the glove box with valves 48, 50 and 24 closed. Inert carrier gas, e.g. argon, is supplied through a shutoff valve 48 to vertical tube 28. It passes through the pnictide contained in the reservoir. Additional argon diluent gas is supplied through a shutoff valve 50 mixes with the argon-carried $Pnictide_4$ species which is then supplied through the metering valve 24 to vacuum pnictide chamber 22 via tube 66 and nozzle 68. The pnictide is deposited on substrate 74.

By-pass valve 52 is utilized initially to purge the system and to equalize the pressure on both sides of the reservoir 30 before start-up of the carrier gas flow through the reservoir 30. The pressure gauge 54 monitors the pressure of the carrier gas and pnictide species being supplied to the metering valve 24.

The temperature of the reservoir 30 is maintained constant by the circulating oil, and, for example, is maintained at a temperature above the melting point of white phosphorus, 44°C, and below its boiling point, 280°C. Typical flow rates through the metering valve 24 are from 10 to 200 millilitres per minute. Typical pressures of, for example, phosphorus $P_4$ and carrier gas supplied, range from 0.1 atmospheres $(1.01 \times 10^4$ Pa) to 25 pounds per square inch $(1.72 \times 10^5$ Pa). The downstream pressures in line 60 range from 0.1 to 1.0 atmospheres (from $1.01 \times 10^4$ to $1.01 \times 10^5$ Pa).

From 6 to 10 millilitres of liquid pnictide may be contained in the reservoir 30 which has a capacity of, say, 30 millilitres.

The pnictide source 26 may be made of glass (phosphorus only) or stainless steel. The carrier gas supply tubing 56, diluent supply tubing 58 and downstream tubing 60 may be stainless steel.

Thin wall tube 28 may have an outside diameter of 0.4 centimetres. The reservoir, which is also thin-walled, may have an outside diameter of 1.5 centimetres. The entire bubbler apparatus, from the bottom 62, of jacket 38 to the top 64 thereof, is 35 centimetres, for example. The englarged portion 36 of the reservoir 30 may have an outside diameter of 2.5 centimetres.

All of the tubing that could come in contact with the Pnictide$_4$ vapour, that is tubing 56, 58 and 60, are preferably surrounded by heating tape (not shown) and maintained at a temperature of about 20C° above that of the reservoir operating temperature to prevent the deposition of pnictide on the surface of the tubing.

Referring to accompanying Figure 2, the pnictide bubbler 20 is employed in a high vacuum deposition system comprising, for example, a modified COOK Model CVE301, high vacuum evaporator 120, which may be diffusion pumped through outlet 122 to a base pressure of less than $10^{-6}$ Torr $(1.33 \times 10^{-4}$ Pa). Substrates 128 may be located approximately 6 inches (15 cms) above source 126 and shielded by a movable shutter 129. A quartz radiant heater 130 is used to control the substrate temperature. Depositions have been made from $10^{-3}$ Torr ($1.33 \times 10^{-1}$ Pa) down.

Two high temperature tungsten crackers are used to convert Pnictide$_4$ species to Pnictide$_2$ species. One is a coil filament 132 directly above the exit cuts 70 in the nozzle 68. The other is a straight wire 134 located 1 inch (2.54 cms) below the substrates in this illustration. Both wires are resistively heated to above 1000°C. P$_4$ species are supplied by the pnictide delivery system 20 through delivery pipe 66 and thence nozzle 68.

A molecular beam deposition apparatus utilizing the pnictide bubbler source is illustrated in accompanying Figure 3. It comprises a vacuum chamber 240, pumped down through vacuum pump port 266 to below $10^{-7}$ to $10^{-8}$ Torr ($1.33 \times 10^{-5}$ - $10^{-6}$ Pa). Then the apparatus is normally run at $10^{-5}$ to $10^{-6}$ Torr ($1.33 \times 10^{-3}$ - $10^{-4}$ Pa). The pnictide delivery system nozzle 68 is substituted for the usual oven source connected to the inlet port 268. Shutter 258 controls the supply of the Pnictide$_4$ species to a water-cooled baffle 246. The collimated P$_4$ species exits the water cooled baffle and is cracked at heated filament 248, which is heated to above 1000°C, to Pnictide$_2$ species which are deposited on substrates 264 mounted on a glass plate 262, mounted to substrate holder 244 on support rod 260.

It is surprising that the pnictide bubbler source may be utilized as a controlled leak to supply the pnictide species to high vacuum systems; that is, vacuum systems operating in the molecular flow regime below $10^{-4}$ Torr ($1.33 \times 10^{-2}$ Pa).

For further details of the thermal cracker and high vacuum systems and also the pnictide delivery system referred to herein, reference may be made to the above-mentioned related applications, in particular those based on USSN 581,139 and USSN 581,102.

Pnictides which may be deposited in accordance with the present invention include phosphorus, arsenic, antimony, bismuth and compounds thereof. Phosphorus deposited by vacuum evaporation and molecular beam deposition has been found to form films of a new form of phosphorus in which the molecules are arranged in a layer-like local order. Such phosphorus films are particularly useful as insulating and passivating layers on III-V semiconductor devices.

- 9 -                          0152668

<u>CLAIMS</u>:

1.    A film deposition apparatus characterised in that
it comprises:

    (A) a reservoir (30) containing heated pnictide;

    (B) means (28) for passing an inert gas therethrough;

    (C) a high vacuum film deposition chamber (22); and

    (D) means (60) for supplying the said inert gas
        carrying the said pnictide as a vapour species
        after passing through the said pnictide to the
        said deposition chamber.

2.    An apparatus as claimed in claim 1 wherein the said
deposition chamber comprises a molecular collimater (246).

3.    An apparatus as claimed in claim 1 or claim 2
comprising a heated pnictide cracker (132, 134) for
cracking pnictide vapour species to $Pnictide_2$ vapour
species.

4.    An apparatus as claimed in claim 3 wherein the said
cracker is an electrically heated filament.

5.    An apparatus as claimed in claim 4 wherein the
said filament is heated to above 1000°C.

6.    A high vacuum deposition process characterised in
that it comprises passing an inert gas through heated
pnictide and supplying the product gas to a vacuum
chamber maintained at a pressure below $10^{-3}$ Torr
($1.33 \times 10^{-1}$ Pa).

7.    A process as claimed in claim 6 wherein the product
gas is collimated in the chamber.

8.    A process as claimed in claim 6 or claim 7 wherein
the product gas is thermally cracked in the chamber.

9.    A process as claimed in any of claims 6 to 8
wherein the pnictide is phosphorus, arsenic or antimony.

10.    A process as claimed in any of claims 6 to 9
wherein deposition takes place in a molecular flow regime.

11.    A process as claimed in claim 10 wherein the pressure
is below $10^{-4}$ Torr ($1.33 \times 10^{-2}$ Pa).

FIG. 1

0152668

1 / 3

# FIG. 2

# FIG. 3